# EUROPÄISCHE PATENTANMELDUNG

(11) **EP 0 766 395 A2**
(43) Veröffentlichungstag der Anmeldung: **02.04.1997**
(21) Anmeldenummer: 96113012.7
(22) Anmeldetag: 13.08.1996
(51) Int. Cl.: H03K 17/082

(54) **Leistungstransistor mit Kurzschlussschutz**

(30) Priorität: 27.09.1995 DE 19535986
(71) Anmelder: SIEMENS AKTIENGESELLSCHAFT, 80333 München (DE)
(72) Erfinder: Jenö, Tihanyi, Dr. Ing., 85551 Kirchheim (DE)

(57) **Zusammenfassung**

Leistungstransistoren, insbesondere MOSFETs und IGBTs müssen, um eine Zerstörung zu vermeiden, im eingeschalteten Zustand vor einem Kurzschluß im Lastkreis ausreichend geschützt werden. Bisher wird der Leistungstransistor beim Auftreten eines Kurzschlußstromes dadurch abgeschaltet, daß deren Gate-Sourcestrecke im Kurzschlußfall über einen Transistor (9) kurzgeschlossen und damit der Leistungstransistor (1) abgeschaltet wird. Erfolgt diese Stromrückregelung zu schnell, kann der Leistungstransistor (1) jedoch durch Überspannung beschädigt werden. Hiergegen hilft eine die Spannungsänderung an der Laststrecke des Leistungstransistors 1) erfassende Spannungssensoranordnung (11, 12, 13), die das Potential am Steueranschluß (G) des Transistors (9) beim Ansteigen der Ausgangsspannung vermindert.

## Beschreibung

Die Erfindung betrifft einen Leistungstransistor mit Kurzschlußschutz und den Merkmalen:
a) Der Leistungstransistor ist mit seiner Laststrecke zwischen eine erste Klemme und eine zweite Klemme und mit seinem Steueranschluß an eine dritte Klemme geschaltet,
b) ein Transistor ist mit seiner Laststrecke zwischen die zweite Klemme und die dritte Klemme geschaltet,
c) eine Stromsensoranordnung ist zum Erfassen des durch den Leistungstransistor fließenden Stromes vorgesehen,
d) die Stromsensoranordnung ist ausgangsseitig mit dem Steueranschluß des Transistors verbunden, um diesen einzuschalten, wenn ein vorgegebener kritischer Wert des Stromes durch den Leistungstransistor überschritten wird.

Die Strombegrenzung im Kurzschlußfall ist ein aktuelles Problem in der Leistungselektronik. Besonders Schaltungsanordnungen mit Leistungstransistoren, wie z. B. MOSFETs und IGBTs, müssen im eingeschalteten Zustand gegen einen auftretenden Kurzschluß im Laststromkreis geschützt werden, da im Kurzschlußfall der Strom durch den Leistungstransistor sehr rasch auf ein Vielfaches des Nennstromes ansteigt und hierdurch der Leistungstransistor gefährdet wird und sogar zerstört werden kann. Die Stromanstiegsgeschwindigkeit ist im Kurzschlußfall von dem im Lastkreis befindlichen Streuinduktivitäten der Zuleitungen abhängig. Um die Zerstörung des Leistungstransistors zu vermeiden, ist es bisher bekannt, den Leistungstransistor im Kurzschlußfall schnell abzuschalten bzw. den Kurzschlußstrom schnell auf ungefährliche Werte zu begrenzen.

Leistungstransistoren mit Kurzschlußschutz sind beispielsweise in der Veröffentlichung Proc. of the 6th Internat. Symposium on Power Semiconductor Decices & IC's, Davos, Switzerland May 31 - June 2, 1994, Seite 31 bis 35 sowie 35 bis 41 beschrieben. Dem Leistungstransistor, ein IGBT, ist eine Stromsensorschaltung, bestehend aus der Reihenschaltung eines Transistors mit Widerstand, parallel geschaltet. Der Verbindungspunkt von Transistor und Widerstand ist mit dem Steueranschluß eines MOSFET in Verbindung, der mit seiner Laststrecke parallel zur Gate-Sourcekapazität des Leistungstransistors geschaltet ist. Der am Widerstand abfallende Spannungsabfall ist ein Maß für den durch den Leistungstransistor fließenden Strom. Sobald der Strom durch den Leistungstransistor einen vorgegebenen kritischen Wert überschreitet, ist dieser Spannungsabfall am Widerstand so groß, daß der MOSFET einschaltet, das Gatepotential am Leistungstransistor sinkt und so der durch den Leistungstransistor fließende Strom vermindert wird. Das Potential am Steueranschluß des Leistungstransistors kann durch den MOSFET der Stromsensoranordnung auch so weit abgesenkt werden, daß der Leistungstransistor vollständig abschaltet.

Es hat sich herausgestellt, daß der Leistungstransistor trotz dieser bekannten Stromrückregelung bzw. Stromabschaltung im Kurzschlußfall beschädigt werden kann. Erfolgt nämlich die Stromrückregelung bzw. Stromanschaltung zu schnell, fällt am Leistungstransistor eine unzulässig hohe Werte annehmende Überspannung ab.

Die Erfindung hat das Ziel, einen Leistungstransistor mit verbessertem Kurzschlußschutz anzugeben.

Diese Aufgabe wird bei dem eingangs genannten Leistungstransistor durch folgende zusätzlichen Merkmale gelöst:
e) Eine Spannungsanordnung ist zum Erfassen der Spannungsänderung an der Laststrecke des Leistungstransistors vorgesehen,
f) die Spannungsanordnung ist ausgangsseitig mit dem Steueranschluß des Transistors verbunden, um das am Steueranschluß des Transistors abgreifbare Potential nach Maßgabe der erfaßten Spannungsänderung zu vermindern.

Weiterbildungen der Erfindung sind Gegenstand der Unteransprüche.

Die Erfindung beruht im wesentlichen darauf, zusätzlich zur Stromsensoranordnung eine Spannungssensoranordnung vorzusehen, um die Spannungsänderung an der Laststrecke des Leistungstransistor im Kurzschlußfall zu erfassen. Die Spannungssensoranordnung, die vorzugsweise eine einwertige Funktion des Kurzschlußstromes durch den Leistungstransistor bereitstellt, ist ausgangsseitig mit dem Steueranschluß des zwischen die zweite und dritte Klemme geschalteten Transistors verbunden, um das dort abgreifbare Potential nach Maßgabe der Spannungsänderung zu vermindern.

Gemäß der Erfindung wird somit durch die Stromsensoranordnung das Gatepotential des Transistors zurückgeregelt, wenn der durch den Leistungstransistor fließende Strom, wie z. B. im Kurzschlußfall, zu hohe Werte annimmt. Zusätzlich wird das Potential am Steueranschluß des Transistors jedoch zurückgenommen, wenn die Ausgangsspannung an der Laststrecke des Leistungstransistors steigt. Durch eine solche dynamische Regelung des Potentials am Steueranschluß des Transistors stellt sich im Kurzschlußfall eine Strombegrenzung und eine Begrenzung der Anstiegsgeschwindigkeit der Lastspannung am Ausgang des Leistungstransistors ein.

Die Erfindung wird nachfolgend anhand von Ausführungsbeispielen im Zusammenhang mit drei Figuren näher erläutert. Es zeigen:
- Figur 1: ein erstes Ausführungsbeispiel eines Leistungs-MOSFET mit verbesserten Kurzschlußschutz,
- Figur 2: ein zweites Ausführungsbeispiel eines Leistungs-MOSFET mit verbesserten Kurzschlußschutz sowie einen steuerbaren Eingangswiderstand und
- Figur 3: ein Ausführungsbeispiel für eine Schaltungsanordnung eines steuerbaren Widerstandes nach Figur 2.

In den nachfolgenden Figuren bezeichnen, sofern nicht anders angegeben, gleiche Bezugszeichen gleiche Teile mit gleicher Bedeutung. Obwohl in den nachfolgenden Ausführungsbeispielen als Leistungstransistor ein Leistungs-MOSFET Verwendung findet, ist die vorliegende Erfindung nicht auf solche Leistungs-MOSFETs beschränkt. Anstelle eines Leistungs-MOSFET kann z. B. auch ein sogenannter IGBT oder FET eingesetzt werden.

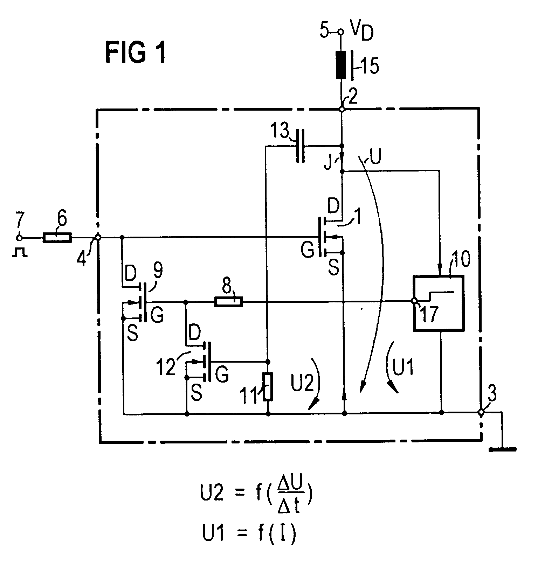

In Figur 1 ist ein Ausführungsbeispiel eines Leistungs-MOSFET 1 mit verbessertem Kurzschlußschutz dargestellt. Der Leistungs-MOSFET 1 ist mit seinen Drainanschluß D an eine erste Klemme 2 und mit seinen Sourceanschluß S an eine zweite Klemme 3, die mit Bezugspotential zu verbinden ist, in Kontakt. Der Gateanschluß G des Leistungs-MOSFET 1 ist an eine dritte Klemme 4 geschaltet. Zwischen diese dritte Klemme 4 und eine weitere Klemme 7, an die ein Steuersignal zum Ein- und Ausschalten des Leistungs-MOSFET 1 anlegbar ist, ist ein Widerstand 6 geschaltet. Im Ausführungsbeispiel von Figur 1 ist an die erste Klemme 2 eine Last 15 geschaltet, die mit ihrem anderen Anschluß an eine weitere Klemme 5 geschaltet ist. An diese Klemme 5 ist eine Versorgungsspannung V_{D} von z. B. +15V anlegbar. Die Last 15 ist im Ausführungsbeispiel von Figur 1 als induktive Last 15 dargestellt. Als induktive Last deshalb, da zumindest in den Zuleitungen zu der ersten Klemme 2 und zweiten Klemme 3 Streuinduktivitäten vorhanden sind.

Zum Kurzschlußschutz des Leistungs-MOSFET 1 weist die in Figur 1 dargestellte Schaltungsanordnung sowohl eine Stromsensoranordnung als auch eine Spannungssensoranordnung auf. Die Stromsensoranordnung ist in Figur 1 mit dem Bezugszeichen 10 bezeichnet. Diese Stromsensoranordnung 10 ist eingangsseitig zwischen den Drainanschluß D und den Sourceanschluß S des Leistungs-MOSFET 1 und damit zwischen die erste Klemme 2 und zweite Klemme 3 geschaltet. Die Stromsensoranordnung 10 ist beispielsweise eine Komparatorschaltung mit zwei möglichen Ausgangssignalen an ihrer Ausgangsklemme 17. Das Ausgangssignal an der Ausgangsklemme 17 ist beispielsweise eine Spannung U1, die zwei Werte annehmen kann. Die Ausgangsklemme 17 ist vorzugsweise über einen Widerstand 8 an den Steueranschluß eines Transistors geschaltet. Dieser Transistor ist im Ausführungsbeispiel von Figur 1 ein Enhancement-MOSFET 9, der mit seinem Drainanschluß D mit der dritten Klemme 4 und mit seinem Sourceanschluß S mit der zweiten Klemme 3 in Verbindung steht. Der Gateanschluß G dieses MOSFET 9 ist an den Widerstand 8 geschaltet.

Die Ausgangsspannung U1 zwischen der Ausgangsklemme 17 der als Komparatorschaltung ausgebildeten Stromsensorschaltung 10 und der zweiten Klemme 3 kann zwei Werte annehmen. Ein erster Wert dieser Spannung U1 ist kleiner als die Einsatzspannung des MOSFET 9 und liegt immer dann an der Ausgangsklemme 17 an, wenn der Strom I durch den Leistungs-MOSFET 1 unterhalb einer vorgegebenen kritischen Schwelle liegt. Diese Schwelle wird so gelegt, daß ein auftretender Kurzschlußstrom über dieser Schwelle liegt. Der im Nennbetrieb fließende Strom I durch den Leistungs-MOSFET 1 liegt dagegen unterhalb dieser Schwelle. Die Ausgangsspannung U1 an der Ausgangsklemme 17 der Stromsensoranordnung 10 kann einen zweiten Wert annehmen, der größer ist als die Einsatzspannung des Leistungs-MOSFET 9. Dieser zweite Wert liegt immer dann an der Ausgangsklemme 17 der Stromsensoranordnung 10, wenn der Strom I durch den Leistungs-MOSFET 1 über der vorgegebenen kritischen Schwelle liegt. Ergebnis ist im Kurzschlußfall, daß der MOSFET 9 einschaltet oder stärker leitend wird, so daß das Potential am Gateanschluß G des Leistungs-MOSFET 1 sinkt. Beträgt beispielsweise die Einsatzspannung des MOSFET 9 +2V und liegt die vorgegebene kritische Schwelle des durch den Leistungs-MOSFET 1 fließenden Stromes bei +50A, so ist die Stromsensoranordnung 10 beispielsweise so dimensioniert, daß die Ausgangsspannung U1 bei einem auftretenden Laststrom I von 5A (Nennbetrieb) 0 V beträgt. Steigt dagegen der Laststrom I auf 100A an (Kurzschlußfall) nimmt die Ausgangsspannung U1 an der Ausgangsklemme 17 der Stromsensoranordnung 10 auf beispielsweise +10V an, so daß der MOSFET 9 stark leitend wird und der Leistungs-MOSFET 1 aufgrund des Absenkens des Potentials an seinem Gateanschluß G ausschaltet.

Um zu vermeiden, daß der Leistungs-MOSFET 1 aufgrund der bis jetzt beschriebenen Schaltungsanordnung im Kurzschlußfall zu schnell abgeschaltet wird und damit eine gefährliche Überspannung im Lastkreis im Leistung-MOSFET 1 auftritt, wird eine Spannungssensoranordnung zum Erfassen der Spannungsänderung an der Laststrecke des Leistungs-MOSFET 1 vorgesehen. Die Spannungssensoranordnung ist ausgangsseitig mit dem Gateanschluß G des MOSFET 9 verbunden, um das dort abgreifbare Potential nach Maßgabe der erfaßten Spannungsänderung zu vermindern. Im einzelnen ist im Ausführungsbeispiel von Figur 1 zur Realisierung der Spannungssensoranordnung ein Kondensator 13, ein Widerstand 11 und ein weiterer Enhancement-MOSFET 12 vorgesehen. Der Kondensator 13 ist mit einem Anschluß an die erste Klemme 2 und mit seinem anderen Anschluß an einen Anschluß des Widerstandes 11 geschaltet. Der Widerstand 11 ist mit seinem noch freien Anschluß an die zweite Klemme 3 geschaltet. Der Verbindungspunkt von Kondensator 13 und Widerstand 11 ist mit dem Gateanschluß G des MOSFET 12 in Verbindung. Der Drainanschluß D dieses MOSFET 12 ist an den Gateanschluß G des MOSFET 9 und der Sourceanschluß S an die zweite Klemme 3 angeschlossen. Die MOSFETs 9 und 12 sind jeweils vom n-Kanaltyp.

Die aus den Schaltungskomponenten 11, 12 und 13 bestehende Spannungssensoranordnung erfaßt die Anstiegsgeschwindigkeit der Spannung U zwischen dem Drainanschluß D und dem Sourceanschluß S des Leistungs-MOSFET 1. Die am Widerstand 11 abfallende Spannung U2 steuert den MOSFET 12. Ist diese Spannung U2 kleiner als die Einsatzspannung des MOSFET 12 bleibt dieser ausgeschaltet und eine Änderung des Potentials am Gateanschluß G des MOSFET 9 tritt nicht ein. Ist dagegen die Spannung U2 größer als die Einsatzspannung des MOSFET 12, wird dieser leitend und damit das Potential am Gateanschluß G des MOSFET 9 zurückgenommen. Die Spannungssensoranordnung, bestehend aus dem Widerstand 11, dem MOSFET 12 und dem Kondensator 13, ist so dimensioniert, daß bei einem sehr schnellen Spannungsanstieg der Spannung U der MOSFET leitend wird und damit tatsachlich das Potential am Gateanschluß G des MOSFET zurückgenommen wird. Ergebnis ist ein Ansteigen des Potentials am Gateanschluß G des Leistungs-MOSFET 1. Damit ist durch die in Figur 1 vorgestellte Schaltungsanordnung im Kurzschlußfall sowohl eine Strombegrenzung als auch eine Begrenzung der Anstiegsgeschwindigkeit der Ausgangsspannung U gewährleistet. Der gesamte Regelvorgang findet nur im Kurzschlußfall statt, da voraussetzungsgemäß bei Normalfunktion und damit Nennstrom die Ausgangsspannung U1 der Stromsensoranordnung 10 unterhalb der Einsatzspannung des MOSFET 9 liegt, so daß dieser ohnehin ausgeschaltet ist.

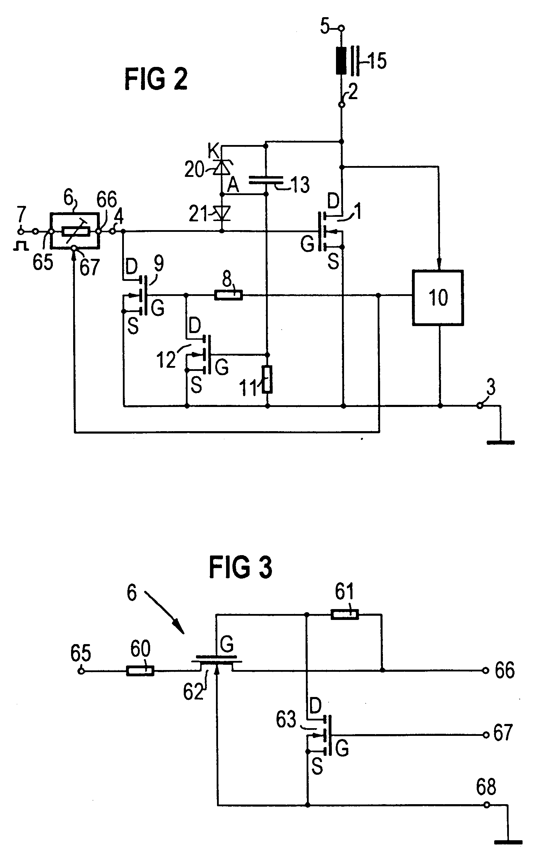

In Figur 2 ist eine Weiterbildung der in Figur 1 dargestellten Schaltungsanordnung gezeigt. Der Widerstand 6 ist als regelbare Widerstandsanordnung, wie diese beispielsweise in Figur 3 dargestellt ist, realisiert. Diese regelbare Widerstandsanordnung 6 ist derart ausgestaltet, daß im Normalbetrieb der Widerstandswert dieser Widerstandsanordnung eine vorgegeben Größe aufweist. Tritt dagegen der Kurzschlußfall auf, wird der Widerstandswert dieser Widerstandsanordnung 6 erhöht. Hierfür ist die Ausgangsklemme 17 der Stromsensoranordnung 10 mit einer als Steueranschluß dienenden Klemme 67 der Widerstandsanordnung 6 verbunden. Die eingangsseitige Klemme 65 ist mit der bereits bekannten Klemme 7 und die ausgangsseitige Klemme 66 mit der zweiten Klemme 4 verbunden.

In Figur 3 ist eine mögliche Ausführungsform der steuerbaren Widerstandsanordnung 6 gezeigt. Zwischen die Klemmen 65 und 66 ist die Reihenschaltung eines Widerstandes 60 mit der Laststrecke eines Depletion-MOSFET 62 geschaltet. Der Gateanschluß dieses Depletion-MOSFET 62 ist über einen weiteren Widerstand 64 an die Klemme 66 geschaltet. Der Gateanschluß des Depletion-MOSFET 62 ist über die Laststrecke eines Enhancement-MOSFET 63 mit einer Klemme 68 in Verbindung. Diese Klemme 68 ist mit Bezugspotential und damit mit der Klemme 3 der Schaltungsanordnung von Figur 1 bzw. Figur 2 zu verbinden. Der Substratanschluß des Depletion-MOSFET 62 ist ebenfalls an diese Klemme 68 angeschlossen. Der Gateanschluß G des Enhancement-MOSFET 63 ist mit der als Steuereingang dienenden Klemme 67 in Kontakt.

Die in Figur 2 dargestellte Schaltungsanordnung weist zusätzlich zu der in Figur 1 vorgestellten Schaltungsanordnung noch zwei Dioden 20, 21 zum Überspannungsschutz der Schaltungsanordnung auf. Hierfür ist eine Zenerdiode 20 mit ihrem Katodenanschluß K an die erste Klemme 2 und mit ihrem Anodenanschluß A an den Verbindungspunkt von Kondensator 13 und Widerstand 11 geschaltet. Eine zweite Diode 21 liegt mit ihrem Katodenanschluß K am Gateanschluß G des Leistungs-MOSFET 1 und mit ihrem Anodenanschluß A am Anodenanschluß der Zenerdiode 20.

Die in den Figuren 1, 2 und 3 dargestellten Schaltungsanordnungen können sowohl diskret als auch integriert in einen Halbleiterkörper realisiert werden. Bei der Integration in einen Halbleiterkörper bietet es sich an, sämtliche Widerstände 8, 9, 60, 61 durch Depletion-MOSFETs zu bilden. Die Dioden 20, 21 können durch MOSFETs realisiert sein.

Anzumerken ist im Zusammenhang mit Figur 2, daß das Steuersignal an der Klemme 67 der steuerbaren Widerstandsanordnung 6 nicht notwendigerweise identisch mit der Ausgangsspannung U1 der Stromsensoranordnung 10 sein muß. Es kann vielmehr zwischen der Klemme 67 der steuerbaren Widerstandsanordnung 6 und der Ausgangsklemme 17 der Stromsensoranordnung 10 eine Einrichtung vorgesehen werden, die ein für die steuerbare Widerstandsanordnung 6 geeignetes Steuersignal generiert, um den Widerstandswert zu erhöhen, sobald an der Ausgangsklemme 17 der Stromsensoranordnung 10 ein den Kurzschlußfall signalisierendes Ausgangssignal anliegt.

## Patentansprüche

1. Leistungstransistor mit Kurzschlußschutz und den Merkmalen:
a) Der Leistungstransistor (1) ist mit seiner Laststrecke zwischen eine erste Klemme (2) und eine zweite Klemme (3) und mit seinem Steueranschluß (G) an eine dritte Klemme (4) geschaltet,
b) ein Transistor (9) ist mit seiner Laststrecke zwischen die zweite Klemme (3) und die dritte Klemme (4) geschaltet,
c) eine Stromsensoranordnung (10) ist zum Erfassen des durch den Leistungstransistor (1) fließenden Stromes vorgesehen,
d) die Stromsensoranordnung (10) ist ausgangsseitig mit dem Steueranschluß des Transistors (9) verbunden, um diesen einzuschalten, sobald ein vorgegebener kritischer Wert des Stromes (I) durch den Leistungstransistor (1) überschritten wird,
**gekennzeichnet** durch die weiteren Merkmale:
e) eine Spannungssensoranordnung (11, 12, 13) ist zum Erfassen der Spannungsänderung an der Laststrecke des Leistungstransistors (1) vorgesehen,
f) die Spannungssensoranordnung (11, 12, 13) ist ausgangsseitig mit dem Steueranschluß (G) des Transistors (9) verbunden, um das am Steueranschluß (G) des Transistors (9) abgreifbare Potential nach Maßgabe der erfaßten Spannungsänderung zu vermindern.

2. Schaltungsanordnung nach Anspruch 1, **dadurch gekennzeichnet**, daß die Stromsensoranordnung (10) eine Komparatorschaltung mit zwei möglichen Ausgangsspannungen (U1) aufweist, daß das erste Ausgangssignal kleiner als die Einsatzspannung des Transistors (9) ist und immer dann am Ausgang der Komparatorschaltung (10) ansteht, wenn der Strom (I) durch den Leistungstransistor (1) unter dem kritischen Wert liegt, und daß das zweite Ausgangssignal größer als die Einsatzspannung des Transistors (9) ist und immer dann am Ausgang der Komparatorschaltung (10) ansteht, wenn der Strom (I) durch den Leistungstransistor (1) über dem vorgegebenen kritischen Wert liegt.

3. Spannungsanordnung nach Anspruch 1 oder 2, **dadurch gekennzeichnet**, daß die Spannungssensoranordnung (11, 12, 13) eine zwischen die erste Klemme (2) und die zweite Klemme (3) geschaltete Reihenschaltung eines Kondensators (13) und eines Widerstandes (11) aufweist, daß der Kondensator (13) mit der ersten Klemme (2) und der Widerstand mit der zweiten Klemme (3) verbunden ist, und daß ein weiterer Transistor (12) mit seiner Laststrecke zwischen den Steueranschluß (G) des Transistors (9) und die zweite Klemme (3) geschaltet und mit seinem Steueranschluß (G) an den Verbindungspunkt zwischen Kondensator (3) und Widerstand (11) angeschlossen ist.

4. Schaltungsanordnung nach Anspruch 3, **dadurch gekennzeichnet**, daß parallel zum Kondensator (13) eine Diode (20) geschaltet ist, deren Katodenanschluß (K) mit der ersten Klemme (2) und deren Anodenanschluß (A) mit dem Verbindungspunkt von Kondensator (13) und Widerstand (11) verbunden ist.

5. Schaltungsanordnung nach Anspruch 3 oder 4, **dadurch gekennzeichnet**, daß eine weitere Diode (21) vorgesehen ist, daß der Katodenanschluß (K) dieser weiteren Diode (21) mit der dritten Klemme (4) und der Anodenanschluß (A) mit dem Verbindungspunkt von Kondensator (13) und Widerstand (11) verbunden ist.

6. Schaltungsanordnung nach einem der Ansprüche 1 bis 5, **dadurch gekennzeichnet**, daß zwischen den Steueranschluß (G) des Transistors (9) und den Ausgang der Stromsensorschaltung (10) ein Widerstand (8) in Reihe liegt.

7. Schaltungsanordnung nach einem der Ansprüche 1 bis 6, **dadurch gekennzeichnet**, daß an die dritte Klemme (4) eine steuerbare Widerstandsanordnung (6) geschaltet ist, daß ein als Steuereingang vorgesehene Klemme (67) dieser Widerstandsanordnung (6) mit dem Ausgang der Stromsensoranordnung (10) verbunden ist, und daß die steuerbare Widerstandsanordnung (6) in ihrem Widerstandswert vergrößerbar ist, sobald der vorgegebene kritische Wert des Stromes (I) durch den Leistungstransistor (1) überschritten wird.

8. Schaltungsanordnung nach Anspruch 7, **dadurch gekennzeichnet**, daß die steuerbare Widerstandsanordnung (6) vier Klemmen (65, 66, 67, 68) aufweist, daß zwischen die erste Klemme (65) und zweite Klemme (66) die Reihenschaltung eines Widerstandes (60) und die Laststrecke eines Depletion-MOSFET (62) geschaltet ist, daß zwischen den Steueranschluß (G) dieses Depletion-MOSFET (62) und die zweite Klemme (66) ein Widerstand (61) geschaltet ist, daß zwischen den Steueranschluß (G) dieses Depletion-MOSFET (62) und die vierte Klemme (68) die Laststrecke eines Enhancements-MOSFET (63) geschaltet ist, daß der Steueranschluß (G) dieses Enhancement-MOSFETs (63) mit der dritten Klemme (67) verbunden ist, und daß die zweite Klemme (66) mit der dritten Klemme (4), die dritte Klemme (67) mit dem Ausgang der Stromsensorschaltung (10) und die vierte Klemme (68) mit der zweiten Klemme (3) verbunden ist.

9. Schaltungsanordnung nach einem der Ansprüche 1 bis 8, **dadurch gekennzeichnet**, daß der Leistungstransistor (1) ein MOSFET ist.

10. Schaltungsanordnung nach einem der Ansprüche 1 bis 8, **dadurch gekennzeichnet**, daß der Leistungstransistor (1) ein IGBT ist.
